# EUROPEAN PATENT APPLICATION

(11) **EP 2 838 090 A1**
(43) Date of publication of application: **18.02.2015**
(21) Application number: 13775960.1
(22) Date of filing: 01.04.2013
(51) Int. Cl.: H01B 12/02, C01G 1/00, H01B 12/06, H01F 6/06

(54) **OXIDE SUPERCONDUCTING WIRE HAVING REINFORCING MATERIALS**

(30) Priority: 10.04.2012 JP 2012089289; 10.04.2012 JP 2012089290
(71) Applicant: Sumitomo Electric Industries, Ltd., Osaka-shi, Osaka 541-0041 (JP)
(72) Inventor: SHINGAI, Yuki, Osaka-shi Osaka 554-0024 (JP); KONISHI, Masaya, Osaka-shi Osaka 554-0024 (JP)
(74) Representative: Hart-Davis, Jason
(86) International application number: PCT/JP2013/059809
(87) International publication number: WO 2013/153973

(57) **Abstract**

Provided is a reinforcing-member-equipped oxide superconducting wire in which occurrence of defects such as separation of a reinforcing member due to a decrease in the strength of an edge portion is sufficiently suppressed, problems such as separation of a reinforcing member do not occur even when a force in a thickness direction is applied, and stable superconducting properties can be maintained. The reinforcing-member-equipped oxide superconducting wire includes an oxide superconducting wire and two reinforcing members that are disposed so as to sandwich the oxide superconducting wire. The reinforcing members are bonded to the oxide superconducting wire using solder, and each of the reinforcing members has a width equal to or smaller than a width of the oxide superconducting wire or at least surfaces of the oxide superconducting wire, the surfaces facing the reinforcing members, are covered with copper, nickel, or an alloy containing at least one of these metals.

## Description

### Technical Field

The present invention relates to a reinforcing-member-equipped oxide superconducting wire in which reinforcing layers are provided by arranging reinforcing members on both surfaces of an oxide superconducting wire.

### Background Art

Since a high-temperature superconductor that exhibits superconductivity at the temperature of liquid nitrogen was discovered, the development of high-temperature superconducting wires that are aimed at applications to cables, current-limiting devices and electric power equipment such as magnets has been actively conducted. In particular, oxide superconducting wires including an oxide superconducting layer composed of, for example, an RE123-based (RE: rare earth element) oxide superconductor oriented on a metal substrate have attracted attention.

In general, reinforcing layers are provided on such an oxide superconducting wire in order to reinforce the strength of the oxide superconducting wire and to protect the oxide superconducting wire from an abnormal current by serving as a bypass. For example, reinforcing layers are provided by arranging reinforcing members such as pieces of metal tape on both surfaces of an oxide superconducting wire and bonding the reinforcing members to the oxide superconducting wire using solder (for example, PTL 1).

### Citation List

### Patent Literature

PTL 1: Japanese Patent No. 3949960

### Summary of Invention

### Technical Problem

However, in the case of the reinforcing-member-equipped oxide superconducting wire of the related art in which reinforcing members arranged on both surfaces of an oxide superconducting wire are bonded using solder as described above, defects may be often generated as described below due to the structure of the reinforcing-member-equipped oxide superconducting wire.

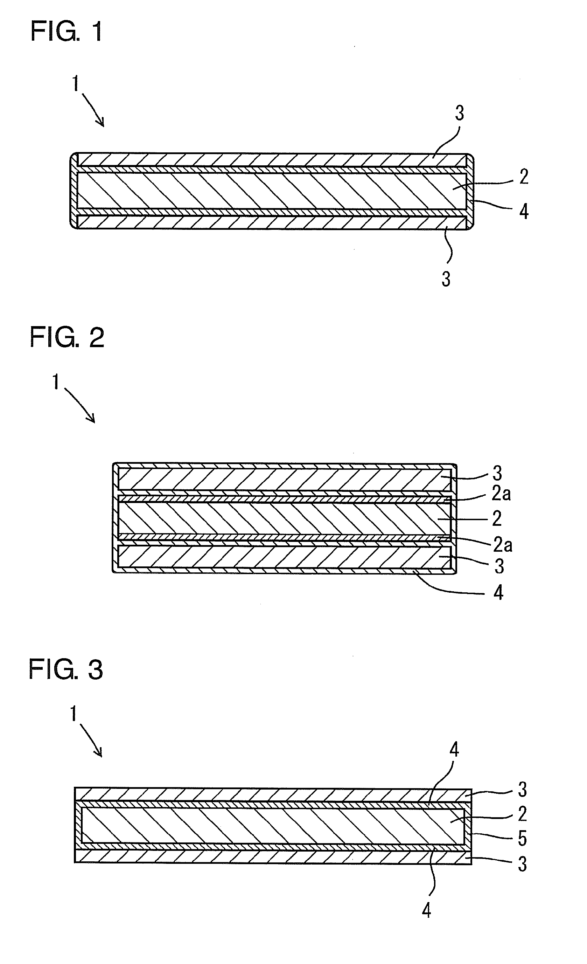

Figure 3 schematically shows a structure of the reinforcing-member-equipped oxide superconducting wire described in PTL1 as a specific example of a reinforcing-member-equipped oxide superconducting wire of the related art. In Fig. 3, reference numeral 1 denotes a reinforcing-member-equipped oxide superconducting wire, reference numeral 2 denotes an oxide superconducting wire, reference numeral 3 denotes a reinforcing member, reference numeral 4 denotes solder (a solder layer), and reference numeral 5 denotes an edge portion (side face portion).

As shown in Fig. 3, the reinforcing-member-equipped oxide superconducting wire 1 includes the oxide superconducting wire 2 and the reinforcing members 3 disposed on both surfaces of the oxide superconducting wire 2. The oxide superconducting wire 2 is bonded to each of the reinforcing members 3 with the solder 4 therebetween. However, the two reinforcing members 3 each have a width larger than a width of the oxide superconducting wire 2, and the gap between the upper reinforcing member 3 and the lower reinforcing member 3 is small. Therefore, it is difficult to make the solder flow along the edge portion 5. It is not easy to make the solder flow through the entire gap between the two upper and lower reinforcing members as shown in Fig. 3. If a portion that is not filled with the solder is formed, the strength of the edge portion 5 decreases. In such a case, when a force is applied, defects such as separation of a reinforcing member occur, and stable superconducting properties may not be maintained. Furthermore, in the case where a refrigerant such as liquid nitrogen is used for cooling, the liquid nitrogen may permeate through the portion that is not filled with the solder. As a result, the portion is expanded by nitrogen vaporized during an increase in the temperature, which may cause ballooning defects that degrade superconducting properties.

Accordingly, an object of the present invention is to provide a reinforcing-member-equipped oxide superconducting wire in which occurrence of defects such as separation of a reinforcing member due to a decrease in the strength of an edge portion is sufficiently suppressed and which can maintain stable superconducting properties.

Furthermore, the reinforcing-member-equipped oxide superconducting wire of the related art in which the reinforcing members disposed on both surfaces are bonded using solder has a problem in that the strength in the thickness direction cannot be sufficiently increased.

Specifically, in an oxide superconducting wire of the related art, in general, a silver layer having a thickness of about 10 nm to 5 µm is provided as a stabilizing layer on the outer periphery of the oxide superconducting wire. In the case where reinforcing members are bonded, using solder, to both surfaces of the oxide superconducting wire on which a silver layer is provided on the outer periphery thereof as described above, silver is eroded by the solder and a Ag-Sn alloy is produced. Since the Ag-Sn alloy produced by erosion is brittle, the Ag-Sn alloy is easily separated and the advantages due to the reinforcing members cannot be sufficiently obtained. As a result, the strength of the interface between the solder and silver decreases, and the following problem may occur. When a force in the thickness direction is applied, for example, when a magnetic field is applied to the reinforcing-member-equipped oxide superconducting wire wound in the form of a coil, the reinforcing members may be separated and a sufficient reinforcing strength cannot be obtained.

Accordingly, another object of the present invention is to provide a reinforcing-member-equipped oxide superconducting wire in which even in the case where a force in the thickness direction is applied, a problem such as separation of a reinforcing member does not occur and a sufficient reinforcing strength can be obtained. Solution to Problem

As a result of intensive studies, the inventors of the present invention found that the above objects can be achieved by the inventions described below and completed the present invention. The invention of each claim will now be described.

An invention according to Claim 1 provides
a reinforcing-member-equipped oxide superconducting wire including an oxide superconducting wire and two reinforcing members that are disposed so as to sandwich the oxide superconducting wire,
in which each of the reinforcing members has a width equal to or smaller than a width of the oxide superconducting wire, and
a solder layer is provided between the oxide superconducting wire and each of the reinforcing members.

In the invention according to this claim, the width of each of the reinforcing members is equal to or smaller than the width of the oxide superconducting wire. Accordingly, even when the two upper and lower reinforcing members are arranged with a narrow gap therebetween, a space is not formed between the reinforcing members and, unlike in the related art, an edge portion that is not filled with solder is not formed. Thus, it is possible to provide a reinforcing-member-equipped oxide superconducting wire in which defects due to a decrease in the strength of such an edge portion are not generated.

An invention according to Claim 2 provides
the reinforcing-member-equipped oxide superconducting wire according to Claim 1, in which the width of each of the reinforcing members is equal to the width of the oxide superconducting wire.

This structure in which the width of each of the reinforcing members is equal to the width of the oxide superconducting wire is preferable because the reinforcing effect can be more significantly exerted.

An invention according to Claim 3 provides
the reinforcing-member-equipped oxide superconducting wire according to Claim 1 or 2, in which a side face portion in a cross section orthogonal to a longitudinal direction of the oxide superconducting wire and the reinforcing members is covered with solder.

Since the width of each of the reinforcing members is equal to or smaller than the width of the oxide superconducting wire, the side face portion in the cross section orthogonal to the longitudinal direction of the oxide superconducting wire and the reinforcing members can be reliably covered with the solder. Accordingly, it is possible to provide a reinforcing-member-equipped oxide superconducting wire in which occurrence of defects due to a decrease in the strength of an edge portion is further suppressed.

An invention according to Claim 4 provides
the reinforcing-member-equipped oxide superconducting wire according to any one of Claims 1 to 3, in which an outer peripheral portion in a cross section orthogonal to a longitudinal direction of the oxide superconducting wire is covered with silver, copper, or an alloy containing at least one of these metals.

Silver (Ag), copper (Cu), or an alloy containing at least one of these metals has good electrical conductivity. Thus, by covering the outer peripheral portion on a cross section orthogonal to the longitudinal direction of the oxide superconducting wire with any of these materials, a protective layer is formed and more stable superconducting properties can be exhibited.

Specific examples of the Ag alloys include Sn-Ag alloys, Cu-Ag alloys, Au-Ag alloys, Ni-Ag alloys, and Pd-Ag alloys. Specific examples of the Cu alloys include Ni-Cu alloys, Sn-Cu alloys, Au-Cu alloys, and Pd-Cu alloys.

An invention according to Claim 5 provides
a reinforcing-member-equipped oxide superconducting wire including an oxide superconducting wire and two reinforcing members that are disposed so as to sandwich the oxide superconducting wire,
in which the reinforcing members are bonded to the oxide superconducting wire using solder, and
at least surfaces of the oxide superconducting wire, the surfaces facing the reinforcing members, are covered with copper, nickel, or an alloy containing at least one of these metals.

Even when copper (Cu), nickel (Ni), or an alloy containing at least one of these metals contacts solder and an alloy of solder-Cu or solder-Ni is produced by erosion, unlike an alloy of solder-silver produced by erosion, the alloy of solder-Cu or solder-Ni is not brittle and breaking on the alloy surface does not easily occur. Therefore, by forming any of these metal layers as a protective layer, even when a force in the thickness direction is applied, a problem such as separation of a reinforcing member does not occur and a sufficient reinforcing strength can be obtained. Note that these metal layers may be formed on an oxide superconducting wire having a stabilizing layer composed of silver or the like thereon.

Specific examples of the Cu alloy include Ni-Cu alloys, Ag-Cu alloys, Sn-Cu alloys, Au-Cu alloys, and Zn-Cu alloy. Specific examples of the Ni alloy include Ag-Ni alloys, Sn-Ni alloys, Zn-Ni alloys, and Au-Ni alloys. Among these alloys, in particular, Ni-Cu alloys are more preferable as the protective layer of the oxide superconducting wire because Ni-Cu alloys are not easily eroded, wettability of solder to these alloys is good, and these alloys have a property that they are not magnetized at low temperatures.

An invention according to Claim 6 provides
the reinforcing-member-equipped oxide superconducting wire according to Claim 5, in which an outer peripheral portion in a cross section orthogonal to a longitudinal direction of the oxide superconducting wire is covered with copper, nickel, or an alloy containing at least one of these metals.

As described above, these metals have sufficient wettability to solder. Accordingly, by covering an outer peripheral portion including not only the surfaces facing the reinforcing members but also both side faces of the oxide superconducting wire, solder can be provided on the outer peripheral portion of the oxide superconducting wire with high adhesiveness, and a higher reinforcing strength can be ensured.

An invention according to Claim 7 provides
the reinforcing-member-equipped oxide superconducting wire according to any one of Claims 1 to 6, in which an outer peripheral portion in a cross section orthogonal to a longitudinal direction is covered with solder.

In the invention according to this claim, an outer peripheral portion in a cross section orthogonal to the longitudinal direction of the reinforcing-member-equipped oxide superconducting wire is covered with solder. Therefore, separation of a reinforcing member is further suppressed and occurrence of defects is further suppressed.

An invention according to Claim 8 provides
the reinforcing-member-equipped oxide superconducting wire according to any one of Claims 1 to 7, having a length of 10 m or more.

Long reinforcing-member-equipped oxide superconducting wires having a length of 10 m or more are used in coils, current-limiting devices, or the like and often have a problem of separation of a reinforcing member. By applying the present invention to such long reinforcing-member-equipped oxide superconducting wires in which a problem of the separation of a reinforcing member may occur, the effects of the present invention are more significantly exhibited.

An invention according to Claim 9 provides
the reinforcing-member-equipped oxide superconducting wire according to any one of Claims 1 to 8, in which the solder is any one of Pb-Sn-based solder, Ag-Sn-based solder, Sn-Cu-based solder, Pb-Sn-Ag-based solder, Pb-Sn-Cu-based solder, and Sn-Ag-Cu-based solder.

Lead (Pb)-Sn-based solder, Ag-Sn-based solder, Sn-Cu-based solder, Pb-Sn-Ag-based solder, Pb-Sn-Cu-based solder, and Sn-Ag-Cu-based solder can be used at relatively low temperatures. The use of such solder is preferable because degradation of superconducting properties at high temperatures can be prevented. In particular, Sn-Cu-based solder, Pb-Sn-Cu-based solder, and Sn-Ag-Cu-based solder are more preferable because erosion of Cu in the oxide superconducting wire is suppressed by the presence of Cu in the solder.

An invention according to Claim 10 provides
the reinforcing-member-equipped oxide superconducting wire according to any one of Claims 1 to 9,
in which the material of the reinforcing members is
nickel, iron, chromium, an alloy containing at least one of these metals,
carbon, silicon, or a flexible material including a fiber containing at least one of carbon and silicon.

Nickel (Ni), iron (Fe), chromium (Cr), or an alloy containing at least one of these metals is preferable as the reinforcing members because these materials have good mechanical properties such as abrasion resistance and a high yield stress.

Specific examples of the Ni alloys include Cu-Ni alloys, Fe-Ni alloys, Cr-Ni alloys, Sn-Ni alloys, and Sn-Ni-Ag alloys. Specific examples of the Fe alloys include Ni-Fe alloys, Cr-Fe alloys, Cu-Fe alloys, Ag-Fe alloys, Sn-Fe alloys, and Sn-Fe-Ag alloys. Specific examples of the Cr alloys include Zn-Cr alloys and Pb-Cr alloys.

Carbon and silicon are also preferable as the reinforcing members because carbon and silicon have good wettability to solder and high strengths. Furthermore, the use of flexible materials produced by solidifying fibers containing at least one of these materials with a resin and the like further improves the strength of the oxide superconducting wire because such flexible materials do not have malleability.

An invention according to Claim 11 provides
the reinforcing-member-equipped oxide superconducting wire according to any one of Claims 1 to 10, in which the oxide superconducting wire includes a thin-film oxide superconducting layer having a thickness of 10 µm or less.

Thin-film oxide superconducting wires usually have a low strength, and separation of a reinforcing member also easily occurs. Application of the present invention to such thin-film oxide superconducting wires is preferable because the effects of the present invention can be significantly exhibited.

### Advantageous Effects of Invention

According to the present invention, it is possible to provide a reinforcing-member-equipped oxide superconducting wire in which occurrence of defects such as separation of a reinforcing member due to a decrease in the strength of an edge portion is sufficiently suppressed and stable superconducting properties can be maintained. Furthermore, according to the present invention, it is possible to provide a reinforcing-member-equipped oxide superconducting wire in which even when a force in a thickness direction is applied, a problem such as separation of a reinforcing member does not occur and a sufficient reinforcing strength can be obtained.

### Brief Description of Drawings

[Fig. 1] Figure 1 is a cross-sectional view that schematically shows a structure of a reinforcing-member-equipped oxide superconducting wire according to an embodiment of the present invention.
[Fig. 2] Figure 2 is a cross-sectional view that schematically shows a structure of a reinforcing-member-equipped oxide superconducting wire according to another embodiment of the present invention.
[Fig. 3] Figure 3 is a cross-sectional view that schematically shows a structure of a reinforcing-member-equipped oxide superconducting wire of the related art. Description of Embodiments

The present invention will now be described on the basis of embodiments with reference to the drawings.

### (Reinforcing-member-equipped oxide superconducting wire)

### 1. Overall structure

### (1) Cross-sectional shape

First, the outline of a reinforcing-member-equipped oxide superconducting wire will be described. Figure 1 is a cross-sectional view that schematically shows a structure of a reinforcing-member-equipped oxide superconducting wire according to an embodiment of the present invention. In Fig. 1, reference numeral 1 denotes a reinforcing-member-equipped oxide superconducting wire, reference numeral 2 denotes an oxide superconducting wire, reference numeral 3 denotes a reinforcing member, and reference numeral 4 denotes solder (a solder layer).

The reinforcing members 3 are disposed on both surfaces of the oxide superconducting wire 2 so as to sandwich the oxide superconducting wire 2. The solder layer 4 is provided between the oxide superconducting wire 2 and each of the reinforcing members 3. Thus, the reinforcing members 3 are bonded to the oxide superconducting wire 2. Side faces of the reinforcing-member-equipped oxide superconducting wire 1 are covered with the solder 4.

Figure 2 is a cross-sectional view that schematically shows a structure of a reinforcing-member-equipped oxide superconducting wire according to another embodiment of the present invention. In Fig. 2, reference numeral 1 denotes a reinforcing-member-equipped oxide superconducting wire, reference numeral 2 denotes an oxide superconducting wire, reference numeral 2a denotes a protective layer, reference numeral 3 denotes a reinforcing member, and reference numeral 4 denotes solder (a solder layer).

The reinforcing members 3 are disposed on both surfaces of the oxide superconducting wire 2 so as to sandwich the oxide superconducting wire 2. The protective layers 2a composed of Cu, Ni, or an alloy containing at least one of these metals are provided on at least surfaces (a top surface and a bottom surface in Fig. 2) of the oxide superconducting wire 2, the surfaces facing the reinforcing members 3. Thus, each of the reinforcing members 3 is bonded to the oxide superconducting wire 2 with the protective layer 2a therebetween by using the solder 4.

The solder 4 is provided between the oxide superconducting wire 2 and each of the reinforcing members 3. However, as shown in Fig. 2, all the surfaces of the reinforcing-member-equipped oxide superconducting wire 1 are preferably covered with the solder 4 because separation of a reinforcing member can be more reliably suppressed.

### (2) Length and form

The length and the form of the reinforcing-member-equipped oxide superconducting wire 1 are not particularly limited. However, as described above, a long reinforcing-member-equipped oxide superconducting wire 1 having a length of 10 m or more is preferable. Also preferable is an oxide superconducting wire 2 produced by forming, on an oriented substrate, a thin-film oxide superconducting layer having a thickness of 10 µm or less.

### 2. Oxide superconducting wire

Next, the oxide superconducting wire 2 will be described. As described above, the oxide superconducting wire 2 includes an oriented substrate and, for example, an RE123-based (RE: rare earth element) oxide superconducting layer formed on the oriented substrate. The width and the thickness of the oxide superconducting wire are appropriately determined according to need. The oxide superconducting wire preferably has a width of about 2 to 30 mm and a thickness of 10 to 200 µm.

### (1) Oriented substrate

The oriented substrate is preferably an oriented substrate obtained by providing an intermediate layer on a metal substrate material. The metal substrate material is preferably an oriented metal substrate that is biaxially oriented in the c-axis. Examples of the substrate that can be used include ion-beam-assisted deposition (IBAD) bases, Ni-W alloy bases, and clad type metal substrate materials including SUS or the like as a base metal. The intermediate layer may be generally composed of CeO₂, stabilized zirconia such as yttria stabilized zirconia (YSZ), Y₂O₃, or the like. From the viewpoint that, for example, a lattice matching property and a critical current density (Jc) can be increased, CeO₂ is used in the uppermost layer.

### (2) Oxide superconducting layer

The oxide superconducting layer is composed of, for example, an RE123-based oxide superconductor. The rare earth element (RE) is preferably yttrium (Y), gadolinium (Gd), holmium (Ho), samarium (Sm), or the like. Examples of a method for forming the oxide superconducting layer include a coating pyrolysis method (metal organic decomposition (MOD) method) and a vapor-phase growth method such as a pulsed laser deposition (PLD) method.

### (3) Protective layer

Next, the protective layer will be described. The protective layer is formed in order to obtain stable superconducting properties or to ensure sufficient adhesiveness to solder. For example, although not shown in Fig. 1, an outer peripheral portion in a cross section orthogonal to a longitudinal direction of an oxide superconducting wire having an oxide superconducting layer thereon is preferably covered with a protective layer composed of silver, copper, or an alloy of these metals. By providing the protective layer, more stable superconducting properties can be exhibited. The thickness of the protective layer for the purpose of obtaining stable superconducting properties is preferably 0.02 to 50 µm, and more preferably 0.02 to 5 µm.

Alternatively, as shown in Fig. 2, a protective layer 2a composed of Cu, Ni, or an alloy containing at least one of these metals is formed. As described above, since these metals have sufficient wettability to solder, sufficient adhesiveness can be ensured. In addition, even when any of these metals contacts solder, the formation of a void due to a reaction between the metal and the solder does not occur. Accordingly, even in the case where a force in the thickness direction is applied, a problem such as separation of the reinforcing member 3 does not occur, and a sufficient reinforcing strength can be obtained. In general, the thickness of the protective layer 2a is preferably about 5 to 20 µm. Examples of a method for forming the protective layer include a plating method and a sputtering method.

Before the formation of the protective layer 2a, a stabilizing layer composed of silver or the like may be formed on a surface of the oxide superconducting wire 2. In this case, the thickness of the stabilizing layer is preferably about 10 nm to 100 µm.

In Fig. 2, only the top surface and the bottom surface of the oxide superconducting wire 2 are covered with the protective layer 2a. Alternatively, the entire outer peripheral surface of the oxide superconducting wire 2 may be covered with the protective layer 2a. With this structure, the solder 4 can be brought into close contact with the entire outer peripheral surface of the oxide superconducting wire, and a more sufficient reinforcing strength can be obtained.

### 3. Reinforcing member

Next, the reinforcing members 3 will be described. A width of each of the reinforcing members 3 is equal to or smaller than a width of the oxide superconducting wire 2. The reinforcing members 3 are arranged such that the width of the reinforcing members 3 does not protrude from the width of the oxide superconducting wire 2. By arranging the reinforcing members 3 in this manner, a gap that inhibits entering of solder is not formed between the two reinforcing members. In order to allow the reinforcing members to sufficiently function, the width of each of the reinforcing members 3 is preferably 50% or more, more preferably 90% or more, and particularly preferably 100% of the width of the oxide superconducting wire 2. The thickness of the reinforcing member 3 is not particularly limited, but is preferably smaller than the thickness of the oxide superconducting wire 2. Specifically, the thickness of the reinforcing member 3 is preferably 5 to 200 µm, and more preferably 50 to 100 µm.

The material of the reinforcing members 3 is preferably Ni, Fe, Cr, or an alloy containing at least one of these metals, as described above.

Carbon (C), silicon, or flexible materials produced by solidifying fibers containing at least one of C and Si with a resin such as an epoxy resin or a fluororesin are also preferable.

### 4. Solder layer

Next, the solder layer 4 will be described. The solder used for forming the solder layer 4 is not particularly limited. For example, Pb-Sn-based solder, Ag-Sn-based solder, Sn-Cu-based solder, Pb-Sn-Ag-based solder, Pb-Sn-Cu-based solder, and Sn-Ag-Cu-based solder can be preferably used.

The solder layer 4 is preferably provided not only between the oxide superconducting wire 2 and each of the reinforcing members 3 but also so as to cover side face portions in a cross section orthogonal to the longitudinal direction of the oxide superconducting wire 2 and the reinforcing members 3, as shown in Fig. 1. Alternatively, the solder layer 4 may be provided not only between the oxide superconducting wire 2 and each of the reinforcing members 3 but also so as to cover an outer peripheral portion in a cross section orthogonal to the longitudinal direction of the reinforcing-member-equipped oxide superconducting wire 1, as shown in Fig. 2. By providing the solder layer 4 in this manner, occurrence of defects due to an insufficient strength of an edge portion is more reliably suppressed, and separation of the reinforcing member 3 is more reliably prevented.

A thickness of the solder layer 4 between the oxide superconducting wire 2 and the reinforcing member 3 is smaller than the thickness of the reinforcing member 3. Specifically, the thickness of the solder layer 4 between the oxide superconducting wire 2 and the reinforcing member 3 is preferably 1 µm or less. A thickness of the solder 4 in the side face portions in the cross section orthogonal to the longitudinal direction of the oxide superconducting wire 2 and the reinforcing members 3 is preferably 10 to 100 µm. In the case where the outer peripheral portion in the cross section orthogonal to the longitudinal direction of the reinforcing-member-equipped oxide superconducting wire 1 is covered with solder, a thickness of the solder 4 on a surface of the reinforcing member 3 is preferably 10 nm to 20 µm.

As described above, according to an embodiment of the present invention, occurrence of defects due to an insufficient strength of an edge portion of the reinforcing-member-equipped oxide superconducting wire can be suppressed, and separation of the reinforcing members can be prevented.

Furthermore, according to another embodiment of the present invention, the reinforcing members and the oxide superconducting wire can be joined to each other with high adhesiveness by using solder. Accordingly, even when a force in the thickness direction is applied, a problem such as separation of the reinforcing members does not occur and a sufficient reinforcing strength can be obtained.

### EXAMPLES

Next, the present invention will be described more specifically by using Examples. In Examples described below, an Y123-based oxide superconducting wire was used as an oxide superconducting wire.

### 1. Preparation of reinforcing-member-equipped oxide superconducting wire

### (EXAMPLE 1)

A reinforcing-member-equipped oxide superconducting wire of this Example was prepared by the procedure described below on the basis of the above embodiments.

### (1) Preparation of oxide superconducting wire

### (a) Preparation of oriented substrate

First, a Ni/Cu/SUS clad type substrate (width 30 mm x length 10 m) in which a Cu layer (thickness: 20 µm), and a Ni layer (thickness: 2 µm) were formed on a SUS layer (thickness: 100 µm) in that order was prepared as a metal substrate.

Next, a CeO₂ layer (thickness: 100 nm), an YSZ layer (thickness: 400 nm), and a CeO₂ layer (thickness: 70 nm) were formed on the surface of the metal substrate in that order by a radio-frequency (RF) sputtering method to form an intermediate layer. Thus, an oriented substrate was prepared.

### (b) Formation of oxide superconducting layer

Next, an Y123 oxide superconducting layer having a thickness of 2 µm was deposited on the oriented metal substrate by a PLD method.

### (c) Formation of protective layer

Next, a Ag layer having a thickness of 5 µm was formed on an outer periphery of the oxide superconducting wire having the oxide superconducting layer thereon by a sputtering method. Thus, the preparation of an oxide superconducting wire was completed.

After the Ag layer was formed, heat treatment was conducted in oxygen so that the oxygen content in the superconducting layer was optimized. After the heat treatment in oxygen, a slitting process was performed, thereby reducing the width of the oxide superconducting wire from 30 mm to 4 mm. Note that even when the order of this slitting process and the heat treatment in oxygen is changed, the present invention is effective.

### (2) Preparation of reinforcing-member-equipped oxide superconducting wire

### (a) Preparation of reinforcing member

Next, two Cu sheets (thickness: 50 µm) each having a width and a length that were equal to those of the above oxide superconducting wire were prepared as reinforcing members.

### (b) Bonding of reinforcing member

The reinforcing members were disposed on both surfaces of the oxide superconducting wire. Subsequently, the oxide superconducting wire and the reinforcing members were joined to each other using Ag-Sn-based solder. In addition, side face portions in a cross section orthogonal to the longitudinal direction of the oxide superconducting wire and the reinforcing members were also covered with the solder. Thus, a reinforcing-member-equipped oxide superconducting wire having a width of 4 mm, a thickness of about 0.22 mm, and a length of 10 m was prepared.

Specifically, a tank containing molten Ag-Sn-based solder was prepared, and the superconducting wire sandwiched between the Cu reinforcing members was passed through the tank to join the oxide superconducting wire to the reinforcing members. This step was continuously performed by using a reel-to-reel system, thereby experimentally producing an Example sample having a length of 10 m.

### (COMPARATIVE EXAMPLE 1)

A reinforcing-member-equipped oxide superconducting wire of Comparative Example 1 was prepared as in Example 1 except that Cu sheets having a width of 4.2 mm, which was larger than the width of the oxide superconducting wire, were used as the reinforcing members and the solder was supplied so that the solder entered between the reinforcing members as much as possible.

### 2. Evaluation

For the reinforcing-member-equipped oxide superconducting wires prepared above, the following items were evaluated.

### (1) Adhesiveness

First, a cross section of each of the reinforcing-member-equipped oxide superconducting wires was embedded in a resin, and each of the resulting samples was cut in the width direction. The cut surface was then polished to expose a cross section. The cross section was observed with an optical microscope. The adhesion state between the oxide superconducting wire, the reinforcing members, and the solder was observed.

According to the results, it was found that, in Example 1, a gap was not observed between the above components, and the oxide superconducting wire, the reinforcing members, and the solder were sufficiently in close contact with each other. In contrast, in Comparative Example 1, it was confirmed that edge portions of the oxide superconducting wire were not completely filled with the solder and depressions were formed in the edge portions. Thus, it was found that sufficient adhesiveness was not ensured.

Next, each of the reinforcing-member-equipped oxide superconducting wires was bent by 180 degrees with each diameter using mandrels having a diameter φ of 20, 30, 40, 50, 60, and 70 mm. The observation was conducted for each diameter as in the observation described above to evaluate the occurrence or nonoccurrence of separation between the oxide superconducting wire, the reinforcing members, and the solder in each bending diameter.

According to the results, in Example 1, separation was not observed between the above components. In contrast, in Comparative Example 1, separation between the oxide superconducting wire and the solder was observed in a bending diameter φ of 30 mm or less.

### (2) Measurement of superconducting properties (Ic)

For each of the reinforcing-member-equipped oxide superconducting wires, a critical current Ic was measured before and after the above bending (direct-current four probe method, 77.3 K, under the self magnetic field) to examine a change in Ic due to the bending.

According to the results, in Example 1, the Ic before bending was 105 A/4 mm width. Even after bending with any bending diameter, the Ic was still 105 A/4 mm width and was not changed. This is because, as described above, separation did not occur even when the bending was performed.

In contrast, in Comparative Example 1, the Ic before bending was 97 A/4 mm width, and the Ic after bending with a diameter φ of 30 mm was decreased to 87 A/4 mm width because separation occurred. After bending with a diameter φ of 20 mm, the Ic was significantly decreased to 50 A/4 mm width.

These results show that stable superconducting properties can be maintained by applying the present invention.

### (EXAMPLE 2)

### (a) Formation of oxide superconducting layer

An intermediate layer and an Y123 oxide superconducting layer that were the same as those in Example 1 were formed in that order on a surface of an oriented substrate the same as that in Example 1.

### (b) Formation of stabilizing layer

Next, a Ag layer having a thickness of 5 µm was formed by a sputtering method on an outer periphery of the oxide superconducting wire on which the oxide superconducting layer was formed.

### (c) Formation of protective layer

Next, a Cu layer having a thickness of 20 µm was formed on an outer periphery of the Ag layer by a plating method. Thus, the preparation of an oxide superconducting wire was completed.

### (2) Preparation of reinforcing-member-equipped oxide superconducting wire

### (a) Preparation of reinforcing member

Next, two Cu sheets (thickness: 30 µm) having a width and a length that were equal to those of the above oxide superconducting wire were prepared as reinforcing members.

### (b) Bonding of reinforcing member

The reinforcing members were disposed on both surfaces of the oxide superconducting wire. Subsequently, the oxide superconducting wire and the reinforcing members were joined to each other using Sn-Ag-Cu-based solder. In addition, side face portions in a cross section orthogonal to the longitudinal direction of the oxide superconducting wire and the reinforcing members were also covered with the solder. Thus, a reinforcing-member-equipped oxide superconducting wire having a width of 4 mm, a thickness of 0.2 mm, and a length of 10 m was prepared.

Specifically, a tank containing molten Sn-Ag-Cu-based solder was prepared, and the superconducting wire sandwiched between the Cu reinforcing members was passed through the tank to join the oxide superconducting wire to the reinforcing members. This step was continuously performed by using a reel-to-reel system, thereby experimentally producing an Example sample having a length of 10 m.

### (COMPARATIVE EXAMPLE 2)

A reinforcing-member-equipped oxide superconducting wire of Comparative Example 2 was prepared as in Example 2 except that the Cu layer functioning as a protective layer was not formed.

### 2. Evaluation

For the reinforcing-member-equipped oxide superconducting wires prepared above, the following items were evaluated.

### (1) Adhesiveness

First, the adhesion state between the oxide superconducting wire, the reinforcing members, and the solder was observed by the same method as that used in Example 1 and Comparative Example 1.

According to the results, it was found that, in Example 2, generation of a void or the like was not observed between the above components, and the oxide superconducting wire, the reinforcing members, and the solder were sufficiently in close contact with each other. In contrast, in Comparative Example 2, it was confirmed that generation of a void was observed in a joined surface between the oxide superconducting wire and the solder. Thus, it was found that sufficient adhesiveness was not ensured.

Next, a force was applied to each of the reinforcing-member-equipped oxide superconducting wires in the thickness direction by applying a magnetic field of 5 T in the thickness direction. Subsequently, the same observation as described above was conducted to evaluate the occurrence or nonoccurrence of separation of a reinforcing member.

According to the results, in Example 2, separation of a reinforcing member was not observed, whereas, in Comparative Example 2, a reinforcing member was separated.

### (2) Measurement of superconducting properties (Ic)

For each of the reinforcing-member-equipped oxide superconducting wires, a critical current Ic was measured before and after the force was applied in the thickness direction (direct-current four probe method, 77.3 K, under the self magnetic field) to examine a change in Ic.

According to the results, in Example 2, the Ic before the application of the force was 120 A/4 mm width. Even after the force was applied, the Ic was still 120 A/4 mm width and was not changed. This is because even when a force is applied, separation of a reinforcing member did not occur and sufficient adhesiveness is maintained.

In contrast, in Comparative Example 2, after the force was applied, the Ic was significantly decreased to 50 A/4 mm width because separation of a reinforcing member occurred.

These results showed that even when a force was applied in the thickness direction, a problem such as separation of a reinforcing member was not caused and a sufficient reinforcing strength could be obtained by applying another embodiment of the present invention. It was also confirmed that, as a result this effect, stable superconducting properties could be maintained.

The present invention has been described on the basis of embodiments, but the present invention is not limited to the above embodiments. Various modifications may be made to the above embodiments within the scope the same as or equivalent to that of the present invention.

### Reference Signs List

- 1: reinforcing-member-equipped oxide superconducting wire
- 2: oxide superconducting wire
- 2a: protective layer
- 3: reinforcing member
- 4: solder (solder layer)
- 5: edge portion (side face portion)

## Claims

1. A reinforcing-member-equipped oxide superconducting wire comprising an oxide superconducting wire and two reinforcing members that are disposed so as to sandwich the oxide superconducting wire,
wherein each of the reinforcing members has a width equal to or smaller than a width of the oxide superconducting wire, and
a solder layer is provided between the oxide superconducting wire and each of the reinforcing members.

2. The reinforcing-member-equipped oxide superconducting wire according to Claim 1, wherein the width of each of the reinforcing members is equal to the width of the oxide superconducting wire.

3. The reinforcing-member-equipped oxide superconducting wire according to Claim 1 or 2, wherein a side face portion in a cross section orthogonal to a longitudinal direction of the oxide superconducting wire and the reinforcing members is covered with solder.

4. The reinforcing-member-equipped oxide superconducting wire according to any one of Claims 1 to 3, wherein an outer peripheral portion in a cross section orthogonal to a longitudinal direction of the oxide superconducting wire is covered with silver, copper, or an alloy containing at least one of these metals.

5. A reinforcing-member-equipped oxide superconducting wire comprising an oxide superconducting wire and two reinforcing members that are disposed so as to sandwich the oxide superconducting wire,
wherein the reinforcing members are bonded to the oxide superconducting wire using solder, and
at least surfaces of the oxide superconducting wire, the surfaces facing the reinforcing members, are covered with copper, nickel, or an alloy containing at least one of these metals.

6. The reinforcing-member-equipped oxide superconducting wire according to Claim 5, wherein an outer peripheral portion in a cross section orthogonal to a longitudinal direction of the oxide superconducting wire is covered with copper, nickel, or an alloy containing at least one of these metals.

7. The reinforcing-member-equipped oxide superconducting wire according to any one of Claims 1 to 6, wherein an outer peripheral portion in a cross section orthogonal to a longitudinal direction is covered with solder.

8. The reinforcing-member-equipped oxide superconducting wire according to any one of Claims 1 to 7, having a length of 10 m or more.

9. The reinforcing-member-equipped oxide superconducting wire according to any one of Claims 1 to 8, wherein the solder is any one of Pb-Sn-based solder, Ag-Sn-based solder, Sn-Cu-based solder, Pb-Sn-Ag-based solder, Pb-Sn-Cu-based solder, and Sn-Ag-Cu-based solder.

10. The reinforcing-member-equipped oxide superconducting wire according to any one of Claims 1 to 9,
wherein the material of the reinforcing members is
nickel, iron, chromium, an alloy containing at least one of these metals,
carbon, silicon, or a flexible material including a fiber containing at least one of carbon and silicon.

11. The reinforcing-member-equipped oxide superconducting wire according to any one of Claims 1 to 10, wherein the oxide superconducting wire includes a thin-film oxide superconducting layer having a thickness of 10 µm or less.
